(19) Europäisches Patentamt
European Patent Office
Office européen des brevets

(11) EP 4 800 741 A1

(12) **EUROPEAN PATENT APPLICATION**
published in accordance with Art. 153(4) EPC

(43) Date of publication:
**02.09.2026 Bulletin 2026/36**

(21) Application number: **24882514.3**

(22) Date of filing: **25.10.2024**

(51) International Patent Classification (IPC):
***H01L 21/60*** *(2006.01)* ***C22C 5/06*** *(2006.01)*
***C22F 1/00*** *(2006.01)* ***C22F 1/14*** *(2006.01)*

(52) Cooperative Patent Classification (CPC):
**C22C 5/06; C22F 1/00; C22F 1/14; H10W 72/071**

(86) International application number:
**PCT/JP2024/038174**

(87) International publication number:
**WO 2025/089406 (01.05.2025 Gazette 2025/18)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **26.10.2023 JP 2023183974**

(71) Applicants:
- **Nippon Micrometal Corporation**
  **Iruma-shi**
  **Saitama 358-0032 (JP)**
- **NIPPON STEEL CHEMICAL & MATERIAL CO., LTD.**
  **Tokyo 103-0027 (JP)**

(72) Inventors:
- **OHKABE, Takumi**
  **Iruma-shi, Saitama 358-0032 (JP)**
- **ODA, Daizo**
  **Iruma-shi, Saitama 358-0032 (JP)**
- **ETO, Motoki**
  **Iruma-shi, Saitama 358-0032 (JP)**
- **OISHI, Ryo**
  **Iruma-shi, Saitama 358-0032 (JP)**
- **OYAMADA, Tetsuya**
  **Tokyo 100-8071 (JP)**
- **UNO, Tomohiro**
  **Tokyo 100-8071 (JP)**

(74) Representative: **Vossius & Partner**
**Patentanwälte Rechtsanwälte mbB**
**Siebertstraße 3**
**81675 München (DE)**

# (54) BONDING WIRE FOR SEMICONDUCTOR DEVICE

(57) The present invention has as its technical challenge maintaining a bond reliability of primary bonding (also called a 1st bonding, FAB bonding, or ball bonding) or secondary bonding (also called a 2nd bonding or wedge bonding) while improving a buildup resistance of a capillary tip to maintain and improve the productivity of the bonding step and has as its object the provision of such an Ag bonding wire.

To solve this technical challenge, the bonding wire is an Ag bonding wire made by an Ag alloy containing In: 0.05 to 3.0 mass%, one or more of Pd, Pt, and Au: 0.010 to 5.0 mass%, one or more of Sc, Ti, and Mn: 0.0005 to 0.050 mass%, and one or more of P, Zn, Bi, and Cu: 0 to 0.030 mass%.



Processed by Luminess, 75001 PARIS (FR)

## Description

FIELD

The present invention relates to bonding wire for a semiconductor device which is utilized for connecting electrodes on a semiconductor chip and external leads and other interconnects of a circuit board.

As bonding wire for a semiconductor device which connects electrodes on a semiconductor chip and external leads (below, sometimes called "bonding wire" or simply "wire" ), fine wires of a wire diameter of 15 to 50 μm or so are mainly being used. Bonding wire is required to exhibit excellent ball formability, ball bondability, wedge bondability, loop formability, etc. To comprehensively satisfy these demands, bonding wire made of Au (gold) has mainly been used. However, Au is expensive, therefore a low cost wire material taking the place of Au has been sought. As one of these, bonding wire made of Ag (silver) (below, called "Ag bonding wire") has been proposed.

For example, PTL 1 proposes Ag bonding wire for securing reliability in a high temperature environment of a molding resin with a high S (sulfur) content and suppressing chip damage at the time of ball bonding by setting suitable contents of Pd and Pt and contents of P, Cr, Zr, and Mo.

PTL 2 and PTL 3 propose Ag bonding wire of a ternary Ag-Pd-Pt system for ultra high frequency signal (several GHz band) use.

PTL 4 proposes Ag bonding wire containing one or more of In, Ga, and Cd for satisfying bond reliability, spring performance, and chip damage performance.

PTL 5 proposes Ag bonding wire containing one or more of Be, B, P, Ca, Y, La, and Ce and one or more of In, Ga, and Cd for securing bond reliability while realizing the bond strength of ball bonding demanded in high density mounting and improving a leaning property of ball necks.

[CITATION LIST]

[PATENT LITERATURE]

[PTL 1] WO2021/205931

[PTL 2] Japanese Unexamined Patent Publication No. 2014-201797

[PTL 3] Japanese Unexamined Patent Publication No. 2014-222725

[PTL 4] Japanese Patent No. 5839763

[PTL 5] WO2017/187653


SUMMARY

[TECHNICAL PROBLEM]

As a measure for dealing with the high density mounting called for in the trend toward higher integration of semiconductor chips, bonding wires are being asked to be improved in stable bond reliability of course and also loop shape controllability. In particular, in Ag bonding wire, for ball bonding to a chip electrode, a wire tip is melted to form a ball (Free Air Ball: FAB). In the process, it was learned that the elements contained in the Ag wire precipitate partially concentratedly at the FAB surface. If some elements precipitate at such an FAB surface, while their precipitates are trace like in amounts, they gradually build up and stick to a capillary tip to form a deposit there (buildup). The buildup at the capillary tip leads to failure of the wire to stick, the wire to detach, etc. and causes the productivity of the bonding step to fall.

The present invention has as its technical challenge to secure the bond reliability of primary bonding (also referred to as 1st bonding, FAB bonding, and ball bonding) and secondary bonding (also referred to as 2nd bonding and wedge bonding) while improving the buildup resistance of the capillary tip and maintaining and improving the productivity of the bonding step and has as its object the provision of such Ag bonding wire.

[SOLUTION TO PROBLEM]

The inventors engaged in intensive studies for meeting the above technical challenge and obtained the following discoveries.

(A) When analyzing the buildup formed on a capillary tip, it was learned that it was comprised of the elements contained in the Ag wire. It is believed that elements included for improving the properties of the bonding wire (in

particular In) locally concentrate at the surface of the FAB at the FAB forming process and when the capillary tip presses the FAB at the time of ball bonding (primary bonding), the concentrated elements deposit at the capillary tip. It was learned that when repeatedly bonding wire tens or hundreds of thousands of times, such precipitates deposit at the capillary tip and form buildup.

(B) The inventors discovered that in the process of incorporating various elements into Ag bonding wire to improve the Ag bonding wire, Sc, Ti, and Mn have the effect of suppressing buildup at the capillary tip (in particular, buildup of In-based compounds). Further, it was confirmed that these elements do not cause deterioration of the bonding wire properties (primary bond reliability, secondary bonding (wedge bonding) reliability, FAB shape controllability, and loop shape controllability).

The present invention was made based on such a discovery and has as its gist the following:

[1] A bonding wire for a semiconductor device comprising

In in 0.05 mass% to 3.0 mass%,
one or more of Pd, Pt, and Au in a total of 0.010 mass% to 5.0 mass%,
one or more of Sc, Ti, and Mn in a total of 0.0005 mass% to 0.050 mass%,
one or more of P, Zn, Bi, and Cu in a total of 0 mass% to 0.030 mass%, and,
a balance of Ag and unavoidable impurities.

[2] A bonding wire for a semiconductor device according to [1], containing one or more of P, Zn, Bi, and Cu in a total of 0.0001 mass% to 0.030 mass%.

[3] A bonding wire for a semiconductor device according to [1] or [2], wherein, in a cross-section of the bonding wire vertical to the wire axis, a ratio of a total of the lengths of twin boundaries to a total of lengths of grain boundaries is 40% or more.

[ADVANTAGEOUS EFFECTS OF INVENTION]

According to the Ag bonding wire according to the present invention, it is possible to secure bond reliability of primary bonding and secondary bonding while suppressing buildup at a capillary tip and maintaining and improving productivity of a bonding step.

DESCRIPTION OF EMBODIMENTS

Below, an embodiment of the present invention (below, simply referred to as the "present invention") will be used as the basis for the explanation. Unless particularly indicated otherwise, the "%" regarding the constituents indicate the mass% in the wire. Cases where no lower limit is particularly prescribed or when the lower limit is made 0% include non-inclusion (0%). Further, as explained above, in this Description, the bonding wire for a semiconductor device will sometimes be referred to as the "bonding wire" or simply the "wire".

[In: 0.05% to 3.0%]

In has the effect of improving the reliability of primary bonding (ball (FAB) bonding) of the Ag bonding wire. For example, when evaluating wire containing In and wire not containing In in an HAST test (high temperature, high humidity test) in an atmosphere of a temperature of 130°C and humidity of 85%, it is confirmed that the time it takes for the shear strength of the ball bonding to become 1/2 of the initial strength in wire containing In becomes two times of more than that of wire not containing In. Therefore, the content of In is 0.05% or more. The lower limit of the In content can be 0.10%, 0.15%, 0.20%, 0.30%, 0.40%, or 0.50%.

On the other hand, if the content of In becomes greater, stress concentrates at the time of ball bonding in the bonding step and the chip is easily damaged. Furthermore, it may be that In easily concentrates at the FAB surface and buildup of In-based precipitates easily forms at the capillary tip. For this reason, the content of In is 3.0% or less. The upper limit of the In content can be 2.7%, 2.5%, 2.3%, 2.1%, or 1.9%.

[One or More of Pd, Pt, and Au: 0.010% to 5.0%]

Pd, Pt, and Au suppress adsorption of S (sulfur) more than Ag (excellent in sulfurization resistance). For this reason, they can suppress sulfurization of the Ag bonding wire surface and prolong the floor life (lifetime of use of bonding wire). Furthermore, these elements are strong in bonding strength with In. By overall inclusion, they are effective for

suppressing deterioration over time due to their synergistic effect. For this reason, the total content of one or more of Pd, Pt, and Au is made 0.010% or more. The lower limit of the total content of these elements can be made 0.030%, 0.050%, 0.070%, 0.100%, 0.200%, 0.300%, 0.400%, or 0.500%.

On the other hand, if the content of Pd, Pt, and Au becomes greater, the specific resistance rises and the electrical conductivity and thermal conductivity deteriorate making the wire unsuitable for use. For this reason, the total content of one or more of Pd, Pt, and Au is made 5.0% or less. The upper limit of the content can be made 4.5%, 4.0%, 3.5%, 3.0%, or 2.5%.

[One or More of Sc, Ti, and Mn: 0.0005% to 0.050%]

It was confirmed that by containing Sc, Ti, and Mn, buildup at the capillary tip (in particular, buildup of In-based precipitates) is suppressed. The mechanism is not clear, but it is believed that by containing Sc, Ti, and Mn, concentration of In at the FAB surface is perhaps suppressed. For this reason, it may be that deposition of In-based precipitates at the capillary tip is suppressed at the time of pressing an FAB by the capillary tip at the bonding step. For this reason, the total content of one or more of Sc, Ti, and Mn is made 0.0005% or more. The lower limit of the content can be made 0.0010%, 0.0020%, 0.0040%, 0.0070%, or 0.010%.

On the other hand, if the content of Sc, Ti, and Mn becomes greater, the strength of the wire itself becomes higher. For example, the breaking strength at the time of secondary bonding (wedge bonding) rises and a spring failures readily occur. For this reason, the total content of one or more of Sc, Ti, and Mn is made 0.050% or less, The upper limit of the content can be made 0.045%, 0.040%, 0.035%, or 0.030%.

[One or More of P, Zn, Bi, and Cu: 0% to 0.030%]

P, Zn, Bi, and Cu may or may not be contained (may also be 0%). However, by including P, Zn, Bi, and Cu, it is possible to improve the sphericity of the FAB shape. This is believed to have an effect on the fluidity and wettability of the melt when the FAB melts and becomes spheroidal and result in better sphericity.

On the other hand, if the content of P, Zn, Bi, and Cu becomes greater, the FAB deteriorates in shape and the primary bondability (ball bondability) deteriorates. For this reason, the total content of one or more of P, Zn, Bi, and Cu should be made 0.030% or less. The upper limit of the content can be made 0.026%, 0.022%, 0.018%, or 0.015%.

To reliably obtain the effect of inclusion of P, Zn, Bi, and Cu, it is sufficient to make the total content of the one or more of P, Zn, Bi, and Cu 0.0001 % or more. The lower limit of the content can be made 0.0005%, 0.0010%, 0.0020%, 0.0030%, 0.0040%, or 0.0050%.

The balance of the composition is comprised of Ag and impurities. Here, the "impurities" means constituents entering due to various factors in the production process such as the raw materials like the silver ingots when industrially producing Ag bonding wire and allowed in an extent not detrimentally affecting the present invention.

[Ratio of Total Length of Twin Boundaries With Respect to Total Length of Grain Boundaries in Cross-Section Vertical to Wire Axis: 40% or More]

The twin boundaries are held stable lower in interfacial energy compared with high-angle grain boundaries in general, therefore are resistant to movement even at a high temperature. For this reason, even when solidified from the molten state in primary bonding (ball bonding), the grains of the wire near the ball are easily maintained, a heat affected zone of the FAB becomes difficult to form, and a drop in strength of the wire is suppressed. For this reason, the strength of a ball neck (upright portion) is secured and the leaning property and loop shape controllability are improved. Furthermore, the twin boundaries can obstruct movement of dislocations in the same way as usual large angle grain boundaries. Further, cross slip occurs at the interfaces, therefore materials with many twin boundaries have similar strengths as usual materials while have excellent ductility. Therefore, complex looping can be formed as targeted. That is, the ratio of twin boundaries becoming greater is effective for loop shape controllability for low loops, high loops, and other complicated looping to deal with the higher density of semiconductor mounting and for the leaning property for avoiding contact with adjoining wires. For this reason, the Ag bonding wire of the present invention preferably has a ratio of the total of the lengths of twin boundaries (total length of twin boundaries) to the total of the lengths of grain boundaries (total length of grain boundaries) at a cross-section vertical to the wire center axis (center axis of bonding wire) of 40% or more. The ratio of the length of the twin boundaries to the length of the grain boundaries may be more preferably 50% or more or 60% or more.

The cross-section vertical to the wire center axis can be exposed by ion beam milling. The total length of the twin boundaries and the total length of the grain boundaries can be found by measuring the wire cross-section as a whole using electron backscatter diffraction (EBSD). EBSD finds the difference in crystal orientation between adjoining measurement points, therefore can identify grain boundaries. Grain boundaries with differences in orientation between adjoining grains of 15 degrees or more are deemed large angle grain boundaries and a region surrounded by large angle grain boundaries

is deemed one grain. Among these, boundaries with specific positional relationships (positional relationships rotated 60 degrees about <111> axis) are twin boundaries. These are calculated by dedicated analysis software (for example, OIM Analysis made by TSL Solutions etc.) together with the total length of grain boundaries. Further, the total of the lengths of the grain boundaries at the cross-section vertical to the wire center axis as a whole is deemed the total length of grain boundaries, the total of the lengths of twin boundaries is deemed the total length of twin boundaries, and the ratio of the total length of twin boundaries to the total length of grain boundaries is found.

[Method of Production of Bonding Wire]

One example of the method of production of the bonding wire according to the present invention will be explained. The method of production of the bonding wire according to the present invention is not limited to the method of production explained below. An Ag bonding wire obtained even by another method of production is included in the bonding wire according to the present invention if satisfying the requirements prescribed in the present invention.

Purity 4N to 5N (99.99% to 99.999%) silver (Ag) is melted and In and other predetermined elements are added in predetermined amounts to obtain a columnar shaped ingot by continuous casting. Next, this ingot is continuously drawn using dies. At that time, 350°C to 550°C intermediate heat treatment and drawing are repeatedly performed to draw the wire to its final diameter. The drawing can be performed using a continuous drawing apparatus set with a plurality of diamond coated dies.

The heat treatment in the middle of the drawing (intermediate heat treatment) may be performed two times. For example, by making the area reduction rate at each stage of drawing (drawing one time) 18% to 30% and performing intermediate annealing at each of the first to third stage of drawing, it is possible to increase the boundary length of twins in the wire (annealing twins).

The area reduction rate per stage may be 18% or more, preferably 20% or more, and may be 30% or less, preferably 28% or less.

The intermediate annealing temperature may be 350°C to 550°C. Preferably, the intermediate heat treatment temperature the first time may be 450°C to 550°C and the second time may be 350°C to 450°C in range. Furthermore, setting the heat treatment temperature the next (second) time lower than the intermediate heat treatment temperature the previous (first) time is effective. Due to this, it is possible to increase the twin boundary lengths.

Furthermore, after the final drawing, final heat treatment may be performed. The temperature conditions of the final heat treatment are, for example, a heat treatment temperature set so that the elongation at break of the wire becomes a predetermined range. The final heat treatment temperature is for example 200 to 700°C in range. The treatment may be performed for 5 seconds or less, preferably 3 seconds or less, or 2 seconds or less. The atmosphere of the heat treatment is for example preferably nitrogen gas, Ar gas, or other inert gas or forming gas (5%$H_2$ -$N_2$) or other nonoxidizing atmosphere.

EXAMPLES

Below, examples will be explained. The raw material Ag used was one with a purity of 99.99% or more and a balance of unavoidable impurities. The In and other elements added used also were ones with a purity of 99.9% or more and a balance of unavoidable impurities.

Ag bonding wires having the chemical compositions shown in Table 1 were produced. To obtain the Ag alloys used for the bonding wires, carbon crucibles formed into columnar shapes were charged with Ag and In and other predetermined materials in predetermined amounts. A high frequency furnace was used to heat the materials in a vacuum or an $N_2$ , Ar gas, or other inert atmosphere up to 1080°C to 1600°C to make them melt. After that, continuous casting was used to obtain φ4 to 6 mm Ag alloy ingots.

The obtained Ag alloy ingots were continuously drawn using dies to thereby prepare φ200 μm to φ600 μm wires. This process is called the "primary drawing step".

After that, the drawing was repeated to obtain wires with a final wire diameter of φ15 μm to φ25 μm. For the drawing, a commercial lubrication solution was used. The wire feed speed at the time of drawing was made 100 m/min to 600 m/min. This step is called the "secondary drawing step". During the secondary drawing, two intermediate heat treatments (first: 450°C to 550°C, second: 350°C to 450°C) were performed. The intermediate heat treatments were performed by continuously running the wires through an Ar gas atmosphere. The feed speeds of the wires at the time of intermediate heat treatments were made 20 m/min to 120 m/min.

The area reduction rate and wire feed speed at the secondary drawing step, the wire diameter at the time of intermediate heat treatments, and further the intermediate heat treatment temperatures were adjusted to adjust the size of the grains and ratio of presence of twins and as a result adjust the ratio of the total length of twin boundaries to the total length of grain boundaries. If adjusting the area reduction rate to be higher, the wire feed speed to be faster, the wire diameter in the intermediate heat treatments to be finer, and the temperatures to be higher, the ratio of twin boundaries

tends to become higher.

After the secondary drawing, final heat treatment was performed so give an elongation at break of the wires of about 9 to 25%. The feed speed of the wires at the time of final heat treatment was 50 m/min to 150 m/min, the final heat treatment temperature was 300°C to 550°C, and the heat treatment time was 0.2 second to 1.0 seconds.

The wire samples described in Table 1 were prepared in this way.

[Evaluation of Primary Bond Reliability]

A sample for evaluation of primary bond reliability was produced as follows: A silicon substrate of a general lead frame was formed with an aluminum (Al) film of a thickness of 1.0 μm. To the electrodes, a commercially available wire bonder was used to bond wire samples by ball bonding. A commercially available epoxy resin (semiconductor use sealant) was used to seal these. Note that, the ball bonding was performed while running $N_2$ +5%$H_2$ gas by a flow rate of 0.4 to 0.6L (liter)/min. The ball diameter was adjusted to become a range of 1.5 to 1.6 times the wire diameter.

The bond reliability was evaluated by a high temperature, high humidity test (HAST). For the evaluation, a bond reliability evaluation sample was exposed to a high temperature, high humidity environment of a temperature of 130°C and a relative humidity of 85% using an unsaturated type pressure cooker tester and given a 5V bias. The bonding life of ball bonding was made the time when the value of the shear strength became half (1/2) of the initially obtained shear strength when performing a shear test of ball bonding every 48 hours. The shear test was performed by removing the resin by acid treatment to expose the ball bonding.

The shear tester for HAST evaluation used a tester made by DAGE. The value of the shear strength was found by obtaining the arithmetic average of the measurement values of 10 randomly selected locations of ball bonds. A bonding life of 288 hours or more was deemed as excellent (E), of 144 hours or more and less than 288 as good (G), and of 96 hours or more and less than 144 hours as fair (F). A bonding life of less than 96 hours was evaluated as poor (P). The results of evaluation are shown in Table 1.

[Evaluation of Secondary Bond Reliability (Wedge Bonding Pull Force)]

A sample for evaluation of the secondary bond reliability was produced as follows: A commercially available wire bonder was used to bond wires by wedge bonding on a Cu alloy lead frame plated with Ag. At that time, wedge bonding was performed at four directions per location (when defining any direction viewing the lead frame from above as the reference direction (0° direction), the four directions clockwise of the 0° direction, 90° direction, 180° direction, and 270° direction) at 80 locations for a total of 320 wires to prepare a sample for evaluation. The sample for evaluation of secondary bond reliability was prepared using wire right after production, wire after storage in a clean room at room temperature for one week, and wire after storage in a clean room at room temperature for two weeks. Pull tests were performed on the respective wedge bonding parts.

The value of the pull force was found by extracting any 15 bonds in each direction and obtaining the arithmetic average of the total 60 in the four directions. A pull force of 4 gf or more was evaluated as excellent (E), of 3 gf or more and less than 4 gf as good (G), and a pull force of less than 3 gf as poor (P). The results of evaluation are shown in Table 1.

[Evaluation of Productivity: Evaluation of Continuous Bondability and Examination of Capillary Tip]

For evaluation of the continuous bondability, the continuous bondability was evaluated using each wire sample by using a commercially available wire bonder to continuously bond 200,000 wires on a Cu alloy frame plated with Ag. The continuous bondability was evaluated by the number of times the apparatus stopped during 200,000 bonding operations. Zero stops of the apparatus were evaluated as excellent (E), one or two stops as good (G), and three or more stops as poor (P). The results of evaluation are shown in Table 1.

Next, after 200,000 continuous bondings, the face of the capillary tip was examined under an SEM and the state of deposition of buildup was visually evaluated. Cases where no formation of buildup could be confirmed at the entire face of the capillary tip or buildup was slightly scattered in extent were evaluated as excellent (E), where it was present in less than 1/4 were evaluated as good (G), and where it was present covering 1/4 or more of the face were evaluated as poor (P). The results of evaluation are shown in the "capillary examination" of Table 1.

[Evaluation of FAB Shape]

The FAB shape was evaluated by using a commercially available wire bonder to form a ball (FAB) for ball bonding for each wire sample. The FAB shape was examined in that state using an SEM. A total of 50 FABs were formed and evaluated. Spherical ones were judged as good (G) and off-centered irregularly shaped ones were judged as poor (P). Cases with zero poor shapes in the 50 FABs were evaluated as excellent (E), with one to two were evaluated as good (G),

and with three or more were evaluated as poor (P). The results of evaluation are shown in Table 1.

[Evaluation of Loop Shape Controllability]

The loop shape controllability was evaluated by the low loop shape controllability and the leaning property.

The low loop shape controllability was evaluated by using a commercially available wire bonder to bond 100 of each wire sample to an evaluation use lead frame by a loop length of 1 mm and a loop height of 60 μm. The presence of any neck damage of a ball bonding was evaluated by an SEM (scan electron microscope). If a crack formed at the neck portion of a ball bonding or a neck portion deformed and a wire became finer, it was judged that the neck had been damaged. If there were three or more necks damaged out of the 100, the wire was judged as poor (P), if there were two, it was judged as fair (F), if there was one, it was judged as good (G), and if there was zero, it was judged as excellent (E). Good and excellent are passing.

The leaning property was evaluated by using a commercially available wire bonder to bond 100 of each wire sample to an evaluation use lead frame by a loop length of 5 mm and a loop height of 0.5 mm. As the method of evaluation, the ball neck of a wire was examined from the chip horizontal direction and the interval between the perpendicular line passing through the center of a ball bonding and the ball neck of the wire when the interval became largest (leaning interval) was found. If the leaning interval was smaller than the wire diameter, the leaning was judged to be good (G), while if it was larger, the ball neck was slanted, therefore the leaning was judged to be poor (P).

For the loop shape controllability, in the evaluation of the 100 wire samples for evaluation of the low loop shape controllability and leaning interval, cases with zero neck damage and zero poor leaning were evaluated as excellent (E), with one neck damage or one to three poor leaning were evaluated as good (G), with two neck damages or four to five poor leaning were evaluated as fair (F), and other cases, that is, with three or more neck damages or six or more poor leanings, were evaluated as poor (P). The results of evaluation are shown in Table 1.

As will be understood from Table 1, the Ag bonding wire according to the present invention is good in primary bond reliability and in secondary bond reliability, is suppressed in buildup at the capillary tip, and has excellent continuous bondability. From this, it was confirmed that according to the Ag bonding wire according to the present invention, productivity of the bonding step was not obstructed. Further, according to the Ag bonding wire according to the present invention, it was confirmed that both the FAB shape and the loop shape controllability were excellent. That is, according to the Ag bonding wire according to the present invention, it was confirmed that it was possible to maintain the bond reliability while maintaining and improving the productivity.

[Table 1]

| Wire sample no. | Composition (mass%) | | | | | | | | | | Ratio of total length of twin boundaries to total length of all grain boundaries (%) | Evaluation of primary bond reliability (HAST) | Evaluation of secondary bond reliability | | | Evaluation of productivity | | FAB shape | Loop shape control-lability | Remarks |
|---|---|---|---|---|---|---|---|---|---|---|---|---|---|---|---|---|---|---|---|---|
| | In | Pd | Pt | Au | Subtotal | Sc | Ti | Mn | Subtotal | Others | | | Initial | After 1 week storage | After 2 weeks storage | Continuous bonding | Capillary examination | | | |
| 1 | 0.60 | 0.800 | | | 0.800 | | | 0.0010 | 0.0010 | | 65 | G | E | E | G | G | G | G | E | Ex. |
| 2 | 0.05 | | 0.010 | | 0.010 | 0.0100 | | | 0.0100 | | 48 | F | G | G | G | E | E | G | G | Ex. |
| 3 | 1.00 | | | 1.100 | 1.100 | | 0.0500 | | 0.0500 | | 55 | E | E | E | E | E | E | G | E | Ex. |
| 4 | 0.30 | 0.150 | 0.150 | | 0.300 | | 0.0300 | | 0.0300 | | 62 | F | G | G | G | E | E | G | E | Ex. |
| 5 | 1.20 | 0.400 | | 0.150 | 0.550 | 0.0100 | | 0.0100 | 0.0200 | | 33 | E | E | E | G | E | E | G | F | Ex. |
| 6 | 3.00 | | | 0.010 | 0.010 | | 0.0100 | | 0.0100 | P: 0.001 | 64 | E | G | G | G | E | E | E | E | Ex. |
| 7 | 0.50 | | 5.000 | | 5.000 | | | 0.0005 | 0.0005 | | 37 | G | E | E | E | G | G | G | F | Ex. |
| 8 | 0.10 | 3.000 | | 0.800 | 3.800 | 0.0020 | | | 0.0020 | Zn: 0.002 | 45 | F | E | E | E | G | G | E | G | Ex. |
| 9 | 2.50 | | 0.008 | 0.007 | 0.015 | | | 0.0250 | 0.0250 | Bi: 0.030 | 60 | E | G | G | G | E | E | E | E | Ex. |
| 10 | 0.20 | 0.800 | | | 0.800 | | 0.0008 | | 0.0008 | | 58 | F | E | E | G | G | G | G | E | Ex. |
| 11 | 0.07 | | | 0.600 | 0.600 | 0.0004 | 0.0004 | | 0.0008 | | 45 | F | E | E | G | G | G | G | G | Ex. |
| 12 | 1.80 | | 2.500 | | 2.500 | | 0.0080 | | 0.0080 | Cu: 0.0005 | 62 | E | E | E | E | E | E | E | E | Ex. |
| 13 | 0.70 | 0.020 | 0.050 | 0.060 | 0.130 | 0.0400 | | | 0.0400 | | 51 | G | G | G | G | E | E | G | G | Ex. |
| 14 | 0.12 | 0.120 | | | 0.120 | 0.0080 | 0.0120 | 0.0100 | 0.0300 | | 52 | F | G | G | G | E | E | G | G | Ex. |
| 15 | 0.20 | 0.400 | | | 0.400 | | 0.0350 | | 0.0350 | P: 0.005 | 59 | F | G | G | G | E | E | E | E | Ex. |
| 1 | 0.03 | | | 0.800 | 0.800 | 0.0100 | | | 0.0100 | | 51 | P | E | E | G | E | E | G | G | Comp. ex. |
| 2 | 0.70 | 0.005 | | | 0.005 | | | 0.0060 | 0.0060 | | 38 | G | P | P | P | E | E | G | F | Comp. ex. |
| 3 | 0.10 | | 1.100 | | 1.100 | | | | 0.0000 | Zn: 0.007 | 50 | F | E | E | E | P | P | E | G | Comp. ex. |
| 4 | 0.50 | 0.200 | | | 0.200 | | | | 0.0000 | | 30 | G | G | G | G | P | P | G | P | Comp. ex. |

[INDUSTRIAL APPLICABILITY]

The present invention can be utilized in the semiconductor industry.

## Claims

1. A bonding wire for a semiconductor device comprising

   In in 0.05 mass% to 3.0 mass%,
   one or more of Pd, Pt, and Au in a total of 0.010 mass% to 5.0 mass%,
   one or more of Sc, Ti, and Mn in a total of 0.0005 mass% to 0.050 mass%,
   one or more of P, Zn, Bi, and Cu in a total of 0 mass% to 0.030 mass%, and,
   a balance of Ag and unavoidable impurities.

2. A bonding wire for a semiconductor device according to claim 1, containing one or more of P, Zn, Bi, and Cu in a total of 0.0001 mass% to 0.030 mass%.

3. A bonding wire for a semiconductor device according to claim 1 or 2, wherein, in a cross-section of the bonding wire vertical to the wire axis, a ratio of a total of lengths of twin boundaries to a total of lengths of grain boundaries is 40% or more.

## INTERNATIONAL SEARCH REPORT

International application No. **PCT/JP2024/038174**

**A. CLASSIFICATION OF SUBJECT MATTER**

***H01L 21/60***(2006.01)i; ***C22C 5/06***(2006.01)i; ***C22F 1/00***(2006.01)i; ***C22F 1/14***(2006.01)i
FI: H01L21/60 301F; C22C5/06 Z; C22F1/00 625; C22F1/00 630M; C22F1/00 661A; C22F1/00 661Z; C22F1/00 681; C22F1/00 685Z; C22F1/00 686A; C22F1/00 691B; C22F1/00 691C; C22F1/00 691Z; C22F1/00 694A; C22F1/14

According to International Patent Classification (IPC) or to both national classification and IPC

**B. FIELDS SEARCHED**

Minimum documentation searched (classification system followed by classification symbols)

H01L21/60; C22C5/06; C22F1/00; C22F1/14

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2023-87638 A (TATSUTA ELECTRIC WIRE & CABLE CO., LTD.) 23 June 2023 (2023-06-23)<br>paragraph [0018] | 1-3 |
| A | JP 6913265 B1 (NIPPON STEEL CHEMICAL & MATERIAL CO., LTD.) 04 August 2021 (2021-08-04)<br>paragraphs [0027], [0052] | 1-3 |
| A | WO 2016/006326 A1 (NIPPON STEEL & SUMIKIN MATERIALS CO., LTD.) 14 January 2016 (2016-01-14)<br>paragraphs [0021], [0027], [0030]-[0031], [0033] | 1-3 |
| A | JP 2014-222725 A (TANAKA ELECTRONICS IND CO., LTD.) 27 November 2014 (2014-11-27) | 1-3 |

☐ Further documents are listed in the continuation of Box C.  ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **28 November 2024** | **10 December 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/038174**

| Patent document cited in search report | Publication date (day/month/year) | Patent family member(s) | Publication date (day/month/year) |
|---|---|---|---|
| JP 2023-87638 A | 23 June 2023 | WO 2023/112444 A1 | |
| | | TW 202323542 A | |
| | | CN 118215990 A | |
| | | KR 10-2024-0122740 A | |
| JP 6913265 B1 | 04 August 2021 | US 2022/0266396 A1 paragraphs [0028]-[0029], [0065]-[0066] | |
| | | WO 2021/100583 A1 | |
| | | EP 3993017 A1 | |
| | | KR 10-2021-0148421 A | |
| | | CN 113906559 A | |
| | | TW 202125532 A | |
| WO 2016/006326 A1 | 14 January 2016 | US 2017/0110430 A1 paragraphs [0020], [0026], [0029]-[0031], [0033] | |
| | | JP 5839763 B1 | |
| | | EP 3029167 A1 | |
| | | KR 10-2016-0028516 A | |
| | | CN 105492637 A | |
| | | CN 107195609 A | |
| | | TW 201602364 A | |
| JP 2014-222725 A | 27 November 2014 | JP 5399581 B1 | |
| | | CN 104157625 A | |
| | | TW 201444005 A | |
| | | KR 10-2014-0134593 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2021205931 A
- JP 2014201797 A
- JP 2014222725 A
- JP 5839763 B
- WO 2017187653 A